# EUROPEAN PATENT APPLICATION

(11) **EP 1 760 792 A1**
(43) Date of publication of application: **07.03.2007**
(21) Application number: 06119075.7
(22) Date of filing: 17.08.2006
(51) Int. Cl.: H01L 29/788, H01L 21/8247

(54) **Nanodot memory and fabrication method thereof**

(30) Priority: 02.09.2005 KR 20050081790
(71) Applicant: Samsung Electronics Co., Ltd., Suwon-si Gyeonggi-do (KR)
(72) Inventor: Seol, Kwang Soo, Gyeonggi-do (KR); Cho, Kyung Sang, Gyeonggi-do (KR); Kim, Byung Ki, Gyeonggi-do (KR); Lee, Eun Hye, Seoul (KR); Choi, Jae Young, Gyeonggi-do (KR)
(74) Representative: Greene, Simon Kenneth

(57) **Abstract**

Disclosed are a nanodot memory formed by applying a metal nanodot colloid solution, which is in a colloidal state, on a semiconductor substrate and thus uniformly arranging nanodot particles with a size of several nanometers on the semiconductor substrate in order to increase the integrity of the memory, and a fabrication method thereof. In the nanodot memory fabrication method, a first insulating film is formed on a surface of a substrate, and a metal nanodot colloid solution is applied on the first insulating film. Subsequently, a solvent inside the metal nanodot colloid solution is evaporated to form a nanodot particles layer, and a second insulating film is formed on the substrate, on the surface of which the nanodot particles are exposed. At this time, the nanodot particles are formed in a monolayer structure by adjusting concentration of metal nanodot particles contained within the metal nanodot colloid solution. By applying a metal nanodot colloid solution on a semiconductor substrate by means of a spin coating method to form monolayer nanodot particles with uniform arrangement, a nanodot memory having a nanodot structure can be easily fabricated.

## Description

### BACKGROUND OF THE INVENTION

The present invention relates to a nanodot memory and a fabrication method thereof, and more particularly to a nanodot memory formed by applying a metal nanodot colloid solution, which is in a colloidal state, on a semiconductor substrate and thus uniformly arranging nanodot particles with a size of several nanometers on the semiconductor substrate in order to increase the integrity of the memory, and a fabrication method thereof.

There is well known a semiconductor structure in which a floating gate capable of storing electric charges is provided as a non-volatile memory device. In particular, the use of such a memory device is rapidly increasing as portable electronic equipments have evolved. With the development of semiconductor technology, a continuous effort is made to reduce power consumption of such a memory device by lowering an operating voltage thereof, and yet to maintain functionality and speed thereof.

In one effective method to realize such an effort, a tunnel oxide film under the floating gate is reduced in thickness, and the floating gate is replaced by a plurality of separate storage elements. A highly integrated memory device can be implemented when nanodot particles are used as such plural separate storage elements.

The nanodot particles have nanometer-scale size, and thus exhibit different optical, magnetic and electrical properties from those in a bulk state. These physical properties, which vary with particle size, are effective for fabricating an optical device having exceptional quantum efficiency, a high-density magnetic recorder, a single-electron transistor and a memory device.

As one of recent methods for fabricating the nanodot particles, a method by use of a nanodot colloid solution containing nanodot particles is the most noticeable. The nanodot colloid solution refers to a solution in which nanodot particles with a size of several nanometers to several micrometers (µm) are uniformly dispersed in a solvent without agglomeration.

US Patent No. 6,413,819 discloses a nanodot memory fabricated using such a nanodot colloid solution.

In most nanodot particle formation methods studied up to date, including the above-mentioned patent, a metal nanodot colloid solution containing metal nanodot particles is dropped onto a substrate by means of a spuit to form arrangement of nanodot particles.

However, these formation methods have a problem in that it is difficult to apply a colloid solution with uniform thickness on a large-area substrate, which results in difficulties in uniformly arranging nanodot particles over the entire substrate.

### SUMMARY OF THE INVENTION

In order to accomplish these objects, there is provided a method for fabricating a nanodot memory in accordance with one aspect of the present invention, the method comprising the steps of: forming a first insulating film on a surface of a substrate; applying a metal nanodot colloid solution on the first insulating film; evaporating a solvent inside the metal nanodot colloid solution to form a nanodot particles layer, forming a second insulating film on the substrate, on the surface of which the nanodot particles are exposed; and forming an upper electrode on the second insulating film, wherein the nanodot particles are formed in a monolayer structure by adjusting concentration of metal nanodot particles contained within the metal nanodot colloid solution.

Preferably, the concentration of the metal nanodot particles contained within the metal nanodot colloid solution amounts to 0.5 to 1.2% by weight (hereinafter referred to as "wt%").

The metal nanodot colloid solution contains metal selected from the group consisting of nickel, cobalt, iron, platinum, silver, palladium and alloys thereof.

Also, the metal nanodot colloid solution contains a nonpolar solvent, and the nonpolar solvent is hexane or diphenylether.

Moreover, the metal nanodot colloid solution contains a dispersant, and the dispersant contains at least one material selected from the group consisting of oleic acid, trioctylamine and trioctylphosphine.

Furthermore, the metal nanodot colloid solution is preferably applied by means of a spin coating method.

The first and second insulating films are selected from the group consisting of a silicone oxide thin film, a silicon oxynitride thin film, a silicon nitride thin film, a titanium oxide thin film, an aluminum oxide thin film or a hafnium oxide thin film, and a laminate thin film thereof.

The second insulating film is formed using a low-pressure chemical vapor deposition process, and the solvent inside the metal nanodot colloid solution is evaporated under a vacuum atmosphere.

After the nanodot particles are formed, the surface of the substrate is treated with oxygen plasma or the substrate is subjected to heat treatment at a temperature of 300°C or above.

In accordance with another aspect of the present invention, there is provided a nanodot memory comprising: a substrate of semiconductor material; a first insulating film being formed on the substrate; metal nanodot gates being formed on the first insulating film by using a metal nanodot colloid solution; a second insulating film being formed on the first insulating film and the metal nanodot gates; and an upper electrode being formed on the second insulating film.

Preferably, the metal nanodot gates are a monolayer of metal nanodot particles, and a distance between the metal nanodot gates amounts to 1 to 10nm.

Also, the material of the metal nanodot gates is selected from the group consisting of nickel, cobalt, iron, platinum, silver, palladium and alloys thereof.

Carbon atomic concentration inside the metal nanodot gates preferably amounts to 2% or less.

The first and second insulating films are selected from the group consisting of a silicone oxide thin film, a silicon oxynitride thin film, a silicon nitride thin film, a titanium oxide thin film, an aluminum oxide thin film or a hafnium oxide thin film, and a laminate thin film thereof.

Accordingly, the present invention aims to solve the above-mentioned problems occurring in the prior art, and an object of the present invention is to provide a nanodot memory, which can be highly integrated by easily forming nanodot particles with uniform arrangement, and a fabrication method thereof.

A further object of the present invention is to provide a method for fabricating a nanodot memory, which can easily form a nanodot particles layer in a monolayer structure by using a nanodot colloid solution.

A further object of the present invention is to provide a method for fabricating a nanodot memory, in which contamination in a device area, in particular, in a critical tunnel oxide portion is reduced through improvements in processes.

### BRIEF DESCRIPTION OF THE DRAWINGS

The above and other objects, features and advantages of the present invention will be more apparent from the following detailed description taken in conjunction with the accompanying drawings, in which:
FIG. 1 is a flowchart of a method for fabricating a nanodot memory in accordance with a preferred embodiment of the present invention;
FIGs. 2 to 4 are sectional views of a nanodot memory formed according to a nanodot memory fabrication method of the present invention;
FIG. 5 is a graph of the result of particles coverage versus metal nanodot particles concentration by weight (in wt%) in a metal nanodot solution employed in a nanodot memory fabrication method in accordance with a preferred embodiment of the present invention, which is measured using TEM (Transmission Electron Microscope) photography when nickel nanodot particles, which is used as metal in the metal nanodot solution, is formed on a first insulating film;
FIG. 6 is a TEM photograph showing arrangement of nanodot particles, which are formed using a metal nanodot colloid solution containing 1.0 wt% nickel nanodot particles;
FIG. 7 is a sectional TEM photograph showing a structure in which a silicon oxide film, a nickel nanodot, a silicon oxide film and an aluminum electrode are sequentially formed on a silicon substrate;
FIGs. 8 to 10 are photographs obtained by continuously magnifying a part of the photograph in FIG. 7 on a larger scale;
FIG. 11 is a graph showing concentration of carbon atoms introduced into a device when the device is treated with oxygen plasma;
FIG. 12 is a graph showing concentration of carbon atoms introduced into a device when the device is not treated with oxygen plasma;
FIG. 13 is a graph showing a measured capacitance-voltage hysteresis characteristic of a capacitor, which is fabricated such that it has the structure in FIG. 7; and
FIG. 14 is a graph showing a flat band voltage characteristic according to maximum sweep voltage.

### DETAILED DESCRIPTION OF THE PREFERRED EMBODIMENTS

Hereinafter, preferred embodiments of the present invention will be described with reference to the accompanying drawings. In the following description and drawings, the same reference numerals are used to designate the same or similar components, and so repetition of the description on the same or similar components will be omitted.

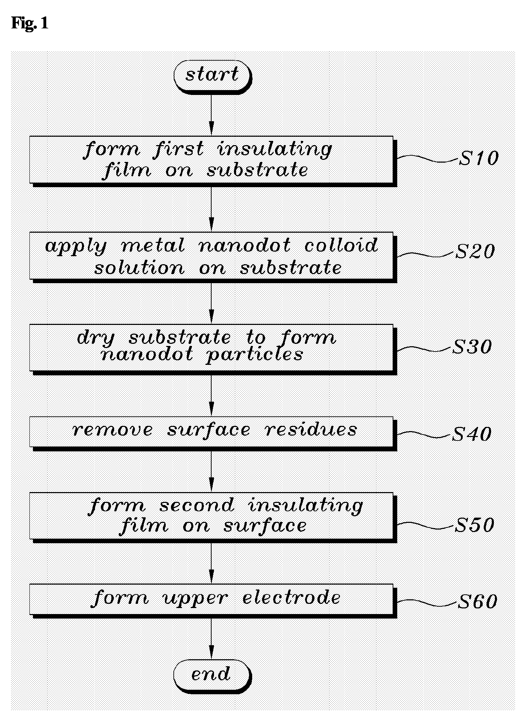

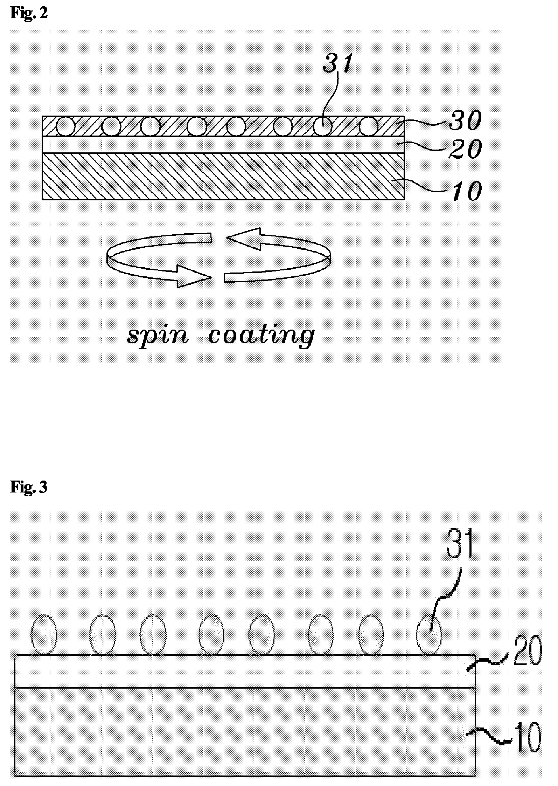

FIG. 1 shows a flowchart of a nanodot memory fabrication method in accordance with a preferred embodiment of the present invention, and Figs. 2 to 4 are sectional views of a nanodot memory fabricated according to a nanodot fabrication method of the present invention.

As shown in FIGs. 1 to 4, in the nanodot memory fabrication method of the present invention, an active area is formed on a substrate 10 of semiconductor material, and a first insulating film 20 is formed on the a surface of the substrate 10 (S10). For example, the first insulating film is selected from the group consisting of a silicone oxide thin film, a silicon oxynitride (SiON) thin film, a silicon nitride thin film, a titanium (Ti) oxide thin film, a tantalum (Ta) oxide thin film, an aluminum (AI) oxide thin film or a hafnium (Hf) oxide thin film, and a laminate thin film thereof.

Next, as shown in FIG. 2, a metal nanodot colloid solution is applied on the first insulating film 20 (S20). At this time, a spin coating method commonly used in a semiconductor fabrication process is employed in the application of the metal nanodot colloid solution. That is, the metal nanodot colloid solution is sprayed onto the substrate 10, and the substrate 10 is continuously spun under conditions of, for example, 5 seconds at 500 rpm, 20 seconds at 2000 rpm and 5 seconds at 500 rpm. As a result of this, the metal nanodot colloid solution is applied with uniform thickness on the substrate 10.

The metal nanodot colloid solution refers to a solution in which metal nanodot particles with nano-scale size are contained in a solvent.

The metal nanodot colloid solution used herein is synthesized with reference to a method as proposed in paper entitled "Monodisperse 3d Transition-Metal Nanoparticles and Their Assembly into Nanoparticle Superlattices", which has been published in the MRS Bulletin, 2001.

As an example, the metal nanodot colloid solution contains nanodot particles, which is formed of metal selected from the group consisting of nickel, cobalt, iron, platinum, silver, palladium and alloys thereof, and the nanodot particles are dissolved into a nonpolar solvent, such as hexane or diphenylether, to thereby be contained in the metal nanodot colloid solution.

Also, the metal nanodot colloid solution contains at least one material as a dispersant, which is selected from the group consisting of oleic acid, trioctylamine and trioctylphosphine. By virtue of such a dispersant, the metal nanodot particles contained within the metal nanodot colloid solution can be uniformly distributed.

Referring to a sectional view shown in FIG. 3, if the substrate, on which the metal nanodot colloid solution 30 is applied, is dried to evaporate the solvent inside the metal nanodot colloid solution, nanodot particles 31 in the form of a layer are formed on the first insulating layer (S30). At this time, it is preferred that the solvent of the metal nanodot colloid solution is evaporated while the substrate 10 is introduced into a vacuum atmosphere. This is because contamination occurring on the substrate 10 can be prevented thereby.

It has been proved that the nanodot particles are formed in a monolayer structure by adjusting concentration of the metal nanodot particles contained within the metal nanodot colloid solution, and the concentration of the metal nanodot particles contained within the metal nanodot colloid solution is preferably 0.5 to 1.2 wt%.

Preferably, residues remaining on the surface of the substrate 10 are subsequently removed (S40).

If the surface of the substrate, on which the nanodot particles 31 are formed, is treated with oxygen plasma or is subjected to heat treatment at 300 or above, residues of the metal nanodot colloid solution remaining on the first insulating film 20 are removed, which prevents contaminant introduction into the fabricated nanodot memory.

Particularly, it has been proved that atomic concentration of carbons introduced into the nanodot memory is controlled to 2% or less by passing through such a residue removal procedure, and thus contaminants are not introduced into the nanodot memory.

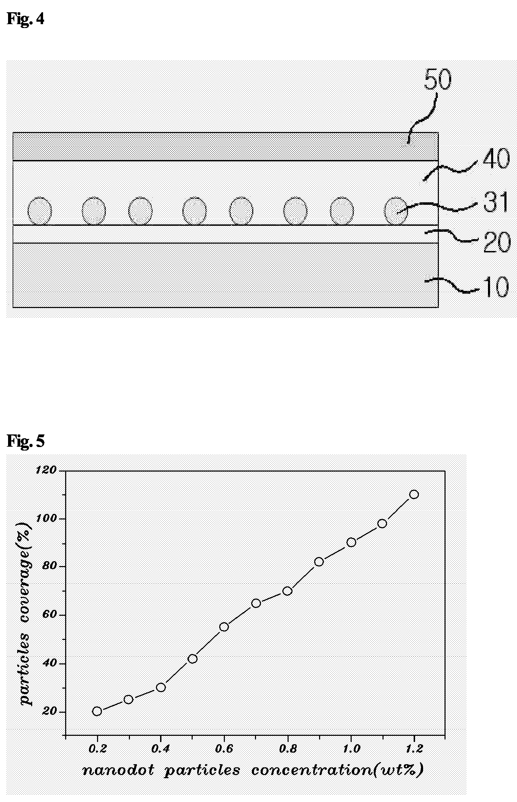

As shown in FIG. 4, a second insulating film 40 is formed over the first insulating film 20, on which the nanodot particles 31 are exposed, and subsequently an upper electrode 50 is formed on the second insulating film 40 (S50, S60). In this way, the nanodot memory fabrication method of the present invention is completed.

The same insulating film as the fist insulating film 20 may be used as the second insulating film 40, and the second insulating film 40 is preferably formed using a low pressure chemical vapor deposition (LPCVD) process in order to reduce leakage current. At this time, the LPCVD process is performed at a temperature range of 400°C to 500°C.

The upper electrode 50 is preferably formed of conductive material having a large work function value, and such material may be selected from the group consisting of nickel, platinum, titanium nitride (TiN), aluminum and polysilicon containing inevitable impurities.

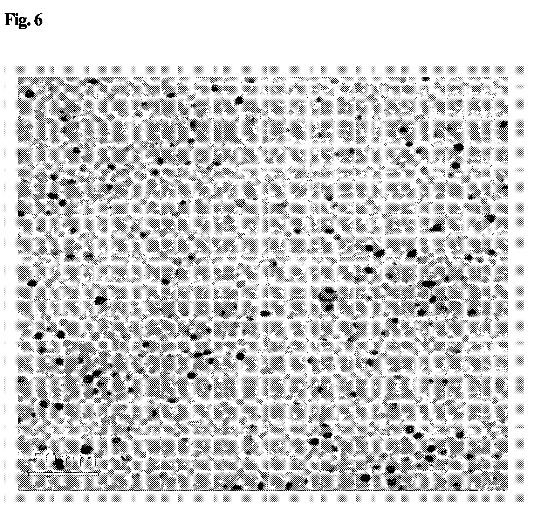

FIG. 5 shows a graph of the result of nanodot particles coverage versus metal nanodot particles concentration by weight (in wt%) in a metal nanodot solution employed in a nanodot memory fabrication method according to a preferred embodiment of the present invention, which is measured using TEM (Transmission Electron Microscope) photography when nickel nanodot particles, which is used as metal in the metal nanodot solution, is formed on a first insulating film. Also, FIG. 6 is a TEM photograph showing arrangement of nanodot particles, which are formed using a metal nanodot colloid solution containing 1.0 wt% nickel nanodot particles.

As shown in FIGs. 5 and 6, when the metal nanodot particles concentration amounts to 1.2 wt%, 90 % of portions to be formed with the metal nanodot particles have a monolayer structure, and there is no metal nanodot particle in only 10 % of that portions. It has been proved that a multilayer structure of nanodot particles is observed and a distance between the metal nanodot particles is reduced to 5 nm if the metal nanodot particles concentration becomes greater than 1.2 wt%.

The distance between the metal nanodot particles can be adjusted by varying the molecular size of the dispersant. At this time, the distance between the metal nanodot particles corresponds to twice of the dispersant size.

Therefore, by forming a nanodot particles layer having the monolayer structure while controlling the distance between the nanodot particles, it is possible to achieve the integrity of the nanodot memory in which the distance between the nanodot particles is ranged from 1 nm to 10 nm.

Also, it has been proved that, if the metal nanodot particles concentration becomes less than 0.5 wt%, an area ratio of the monolayer structure is reduced to 50% or less, and portions occupied by the nanodot particles also decrease. Consequently, the coverage of particles having the monolayer structure can be adjusted by regulating the metal nanodot particles concentration in the metal nanodot colloid solution.

In condusion, if the metal nanodot particles concentration in the metal nanodot colloid solution is set to, for example, 0.5 to 1.2 wt% based on the above-mentioned results, the nanodot particles in the monolayer structure can be formed from the metal nanodot colloid solution applied on the first insulating film 20.

Hereinafter, the resultant nickel nanodot memory fabricated by the nanodot memory fabrication method of the present invention will be described by way of example.

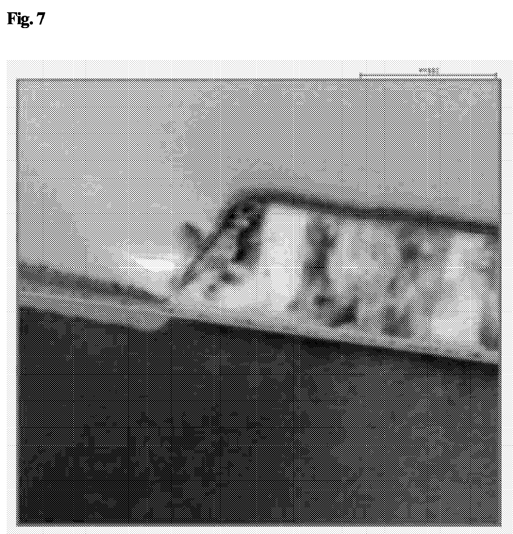

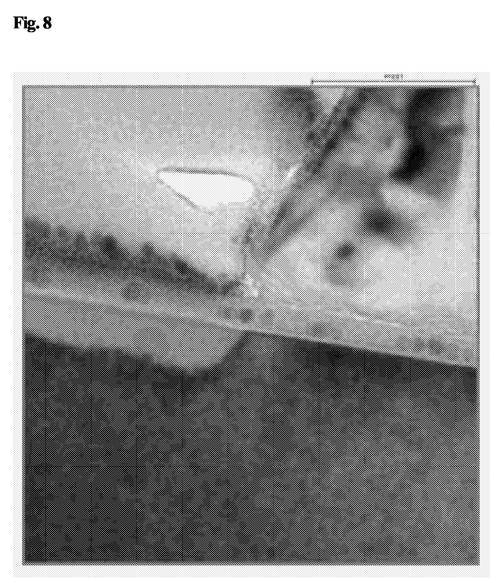

FIG. 7 shows a sectional TEM photograph of a structure in which a silicon oxide film, a nickel nanodot, a silicon oxide film and an aluminum electrode are sequentially formed on a silicon substrate, and FIGs. 8 to 10 show photographs obtained by continuously magnifying a part of the photograph in FIG. 7 on a larger scale.

The photographs observed by transmission electron microscopy dearly represent silicon oxide film and nickel nanodot particles arranged in a monolayer structure. As verified in the photographs, the size of the nickel nanodot particles is about 9 nm, and a distance between the nickel nanodot particles is about 5 nm.

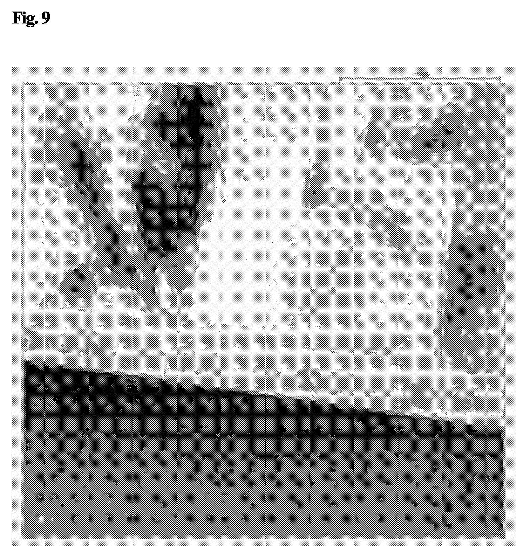

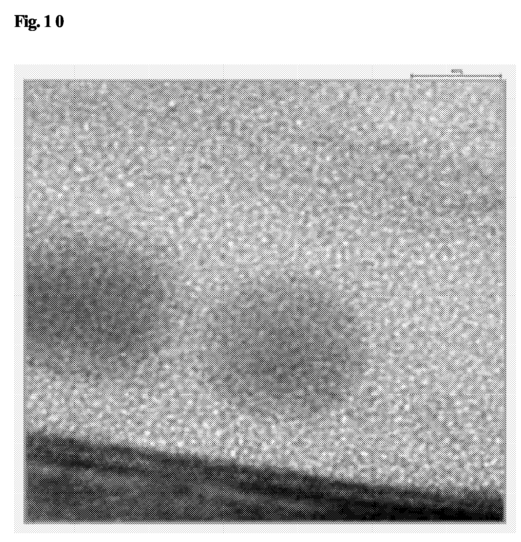

As shown in FIGs. 9 and 10, it has been proved that the nickel nanodot particles are uniformly distributed within the insulating films.

In order to verify the effect of the residue removal process in the nanodot memory fabrication method of the present invention, contamination due to carbon introduction into the nanodot memory is analyzed, and the analysis result is as follows:

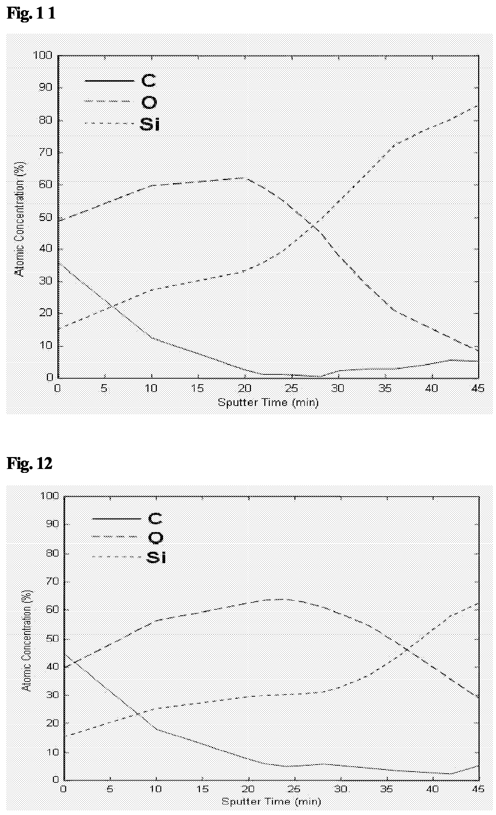

FIG. 11 shows a graph showing concentration of carbon atoms introduced into a device when the device is treated with oxygen plasma, and FIG. 12 shows a graph showing concentration of carbon atoms introduced into a device when the device is not treated with oxygen plasma.

The graphs in FIGs. 11 and 12 correspond to those obtained by analyzing components along a vertical direction according to secondary ion mass spectroscopy for the nanodot memory structure of the present invention. The abscissa axis of the graphs indicates a depth directional sputter time in minute, and the ordinate axis of the graphs indicates atomic concentration in %.

On the abscissa axis, the sputter time of 0 to 20 minutes represents a silicon oxide film area of the second insulating film, and the sputter time of 20 to 35 minutes represents a nickel nanodot area and a silicon oxide film area of the first insulating film. The silicon oxide film area is converted into a silicon substrate area around the sputter time of 35 minute.

By comparison of the results in FIGs. 11 and 12, it can be seen that the carbon atomic concentration in the nickel nanodot area and the first insulating film area is reduced from 4% or greater to 2% or less when residues are removed through the oxygen plasma treatment. The same residue removal effect is also obtained when heat treatment is performed at a temperature of 300°C or above.

Hereinafter, a nanodot memory in accordance with another embodiment of the present invention will be described with reference to FIGs. 4 and 7 to 10.

The nanodot memory according to this embodiment, which is fabricated by the nanodot memory fabrication method of the present invention, includes a substrate 10, a first insulating film 20, metal nanodot gates 31, a second insulating film 40 and an upper electrode 50. In such a nanodot memory, the metal nanodot gates 31 are formed using a metal nanodot colloid solution, and a distance between the metal nanodot gates 31 amounts to 5 nm or less.

To be specific, the substrate 10 is one made of semiconductor material such as silicon and compounds thereof, and the first insulating film 20 is formed on the substrate 10. The metal nanodot gates 31 arranged on the first insulating film 20 are monolayer nanodot particles, which are formed by the nanodot memory fabrication method of the present invention.

The second insulating film 40 is formed on the first insulating film 20 and the metal nanodot gates 31, and the upper electrode 50 is formed on the second insulating film 40.

Preferably, the first and second insulating films 20, 40 are selected from the group consisting of a silicone oxide thin film, a silicon oxynitride thin film, a silicon nitride thin film, a titanium oxide thin film, an aluminum oxide thin film or a hafnium oxide thin film, and a laminate thin film thereof. Also, it is preferred that material of the metal nanodot gates is selected from the group consisting of nickel, cobalt, iron, platinum, silver, palladium and alloys thereof.

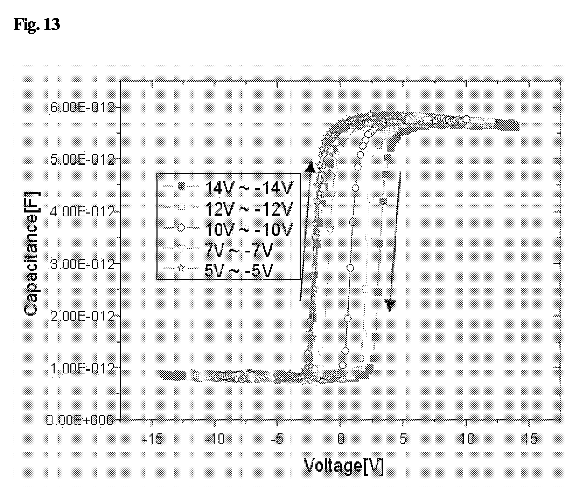

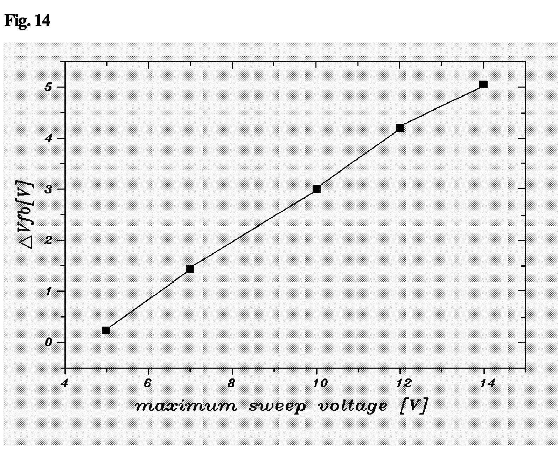

FIG. 13 is a graph showing a measured capacitance-voftage hysteresis characteristic of a capacitor, which is fabricated such that it has the structure in FIG. 7, and FIG. 14 is a graph showing a flat band voltage characteristic according to maximum sweep voltage.

FIGs. 13 and 14 demonstrate the charge accumulation capability of a nanodot memory structure formed using an n-type silicon substrate, and FIG. 14 represents the flat band voltage (ΔVfb) as a function of the maximum sweep voltage, which is derived using FIG. 13.

The results in FIGs. 13 and 14 prove that the nanodot memory fabricated according to the present invention has electrical properties comparable with those of non-volatile memories used in the present time, through which the superiority of the present invention can be verified.

As describe above, a nanodot memory and a nanodot memory fabrication method of the present invention have the following advantages:
A nanodot memory having a nanodot structure can be easily fabricated in such a manner that a metal nanodot colloid solution is applied on a substrate by means of a spin coating method to form monolayer nanodot particles with uniform arrangement.
Also, nanodot particles for fabricating a nanodot memory can be easily formed in a monolayer structure by adjusting concentration of metal nanodot particles contained within a metal nanodot colloid solution.

Moreover, nanodot particles formed on a first insulating film are treated with oxygen plasma or are subjected to heat treatment, so that organic contamination in a device area of a nanodot memory, particularly in a critical tunnel oxide portion, can be reduced.

Although preferred embodiments of the present invention have been described for illustrative purposes, those skilled in the art will appreciate that various modifications, additions and substitutions are possible, without departing from the scope of the invention as disclosed in the accompanying claims.

## Claims

1. A method for fabricating a nanodot memory, the method comprising the steps of:
forming a first insulating film on a surface of a substrate;
applying a metal nanodot colloid solution on the first insulating film;
evaporating a solvent inside the metal nanodot colloid solution to form a nanodot particles layer;
forming a second insulating film on the substrate, on the surface of which the nanodot particles are exposed; and
forming an upper electrode on the second insulating film,
wherein the nanodot particles are formed in a monolayer structure by adjusting the concentration of metal nanodot particles contained within the metal nanodot colloid solution.

2. The method as claimed in claim 1, wherein the concentration of the metal nanodot particles contained within the metal nanodot colloid solution amounts to 0.5 to 1.2 wt%.

3. The method as claimed in claim 1 or 2, wherein the metal nanodot colloid solution contains metal selected from the group consisting of nickel, cobalt, iron, platinum, silver, palladium and alloys thereof.

4. The method as claimed in any preceding claim, wherein the metal nanodot colloid solution contains a nonpolar solvent.

5. The method as claimed in claim 4, wherein the nonpolar solvent is hexane or diphenylether.

6. The method as claimed in any preceding claim, wherein the metal nanodot colloid solution contains a dispersant

7. The method as claimed in claim 6, wherein the dispersant contains at least one material selected from the group consisting of oleic add, trioctylamine and trioctylphosphine.

8. The method as claimed in any preceding claim, wherein the metal nanodot colloid solution is applied by means of a spin coating method.

9. The method as claimed in any preceding claim, wherein the first and second insulating films are selected from the group consisting of a silicone oxide thin film, a silicon oxynitride thin film, a silicon nitride thin film, a titanium oxide thin film, an aluminum oxide thin film or a hafnium oxide thin film, and a laminate thin film thereof.

10. The method as claimed in any preceding claim, wherein the second insulating film is formed using a low-pressure chemical vapor deposition process.

11. The method as claimed in any preceding claim, wherein the solvent inside the metal nanodot colloid solution is evaporated under a vacuum atmosphere.

12. The method as claimed in any preceding claim, wherein after the nanodot particles are formed, the surface of the substrate is treated with oxygen plasma

13. The method as claimed in any preceding claim, wherein after the nanodot particles are formed, the substrate is subjected to heat treatment at a temperature of 300°C or above.

14. A nanodot memory comprising:
a substrate of semiconductor material;
a first insulating film formed on the substrate;
metal nanodot gates formed on the first insulating film by using a metal nanodot colloid solution;
a second insulating film being formed on the first insulating film and the metal nanodot gates; and
an upper electrode being formed on the second insulating film.

15. The nanodot memory as claimed in claim 14, wherein the metal nanodot gates are a monolayer of metal nanodot particles

16. The nanodot memory as claimed in claim 14 or 15, wherein a distance between the metal nanodot gates amounts to 1 to 10 nm.

17. The nanodot memory as claimed in daim 14, 15 or 16, wherein material of the metal nanodot gates is selected from the group consisting of nickel, cobalt, iron, platinum, silver, palladium and alloys thereof.

18. The nanodot memory as claimed in any of claims 14 to 17, wherein carbon atomic concentration inside the metal nanodot gates amounts to 2% or less.

19. The nanodot memory as claimed in any of claims 14 to 18, wherein the first and second insulating films are selected from the group consisting of a silicone oxide thin film, a silicon oxynitride thin film, a silicon nitride thin film, a titanium oxide thin film, an aluminum oxide thin film or a hafnium oxide thin film, and a laminate thin film thereof.
